(19) Europäisches Patentamt
European Patent Office
Office européen des brevets

(11) **EP 4 734 376 A1**

(12) **EUROPEAN PATENT APPLICATION**

(43) Date of publication:
29.04.2026 Bulletin 2026/18

(51) International Patent Classification (IPC):
**H03M 7/14** $^{(2006.01)}$   **H04L 25/49** $^{(2006.01)}$
**H04L 27/00** $^{(2006.01)}$

(21) Application number: 25210017.7

(22) Date of filing: **21.10.2025**

(52) Cooperative Patent Classification (CPC):
**H03M 7/14; H04L 25/4927; H04L 27/0008**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **22.10.2024 US 202463710095 P
17.03.2025 US 202519081429**

(71) Applicant: **Avago Technologies International
Sales
Pte. Limited
Singapore 768923 (SG)**

(72) Inventor: **Pulikkoonattu, Rethnakaran
Irvine, 92618 (US)**

(74) Representative: **Dilg, Haeusler, Schindelmann
Patentanwaltsgesellschaft mbH
Leonrodstraße 58
80636 München (DE)**

(54) **COMMUNICATION DEVICE WITH SCALABLE FIXED-POINT NUMERICAL FORMAT**

(57)    A circuit for enhancing the resolution of a numerical value in existing circuitry using a scalable fixed-point binary format. The scalable fixed-point format positions the bit representing the lowest numerical value (the resolution) with the greatest bit index. The circuit separates the bit representing the lowest numerical value from the remaining portion of a binary encoded number. Legacy processing can be performed on the remaining portion of the binary encoded number. The removed bit is used to select between legacy processing and the output of new processes and/or circuits. The scalable fixed-point binary format can be used to represent modulation and coding schemes (MCS) in a wireless communication standard allowing for new MCS identifiers to be added between existing MCS identifiers using enhanced resolution and while maintaining a monotonic relationship between the identifier and the effective data transfer rate of the MCS.

FIG. 3

**Description**

BACKGROUND

The present disclosure relates to formats for representing numerical values using a number of binary symbols.
In certain applications, numerical values are represented using a number of binary symbols (e.g., logic '0' or '1') in a fixed-point format wherein the resolution of the representation is fixed and each position within the fixed-point representation has the same value regardless of the size of the numerical value.

BRIEF DESCRIPTION OF THE DRAWINGS

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements.

FIG. 1A is a block diagram depicting a network environment including one or more access points in communication with one or more devices or stations, according to some embodiments.

FIG. 1B is a block diagram depicting computing devices useful in connection with the methods and systems described herein, according to some embodiments.

FIG. 1C is another block diagram depicting computing devices useful in connection with the methods and systems described herein, according to some embodiments.

FIG. 2 illustrates various fixed-point formats for representing numerical values with a binary encoding, according to some embodiments.

FIG. 3 is a block diagram depicting a circuit for incorporating increased resolution of fixed-point representation of numerical values with legacy circuitry, according to some embodiments.

FIG. 4 is a block diagram of the separation circuit of FIG. 3 depicting the inputs and outputs, according to some embodiments.

FIG. 5 is a block diagram of the selection circuit of FIG. 3 depicting the inputs and outputs, according to some embodiments.

FIG. 6 is a block diagram depicting a circuit for which the resolution of a fixed-point representation has been increased twice, according to some embodiments.

FIG. 7 is a block diagram of the selection circuit for FIG. 6 depicting the inputs and outputs, according to some embodiments.

FIG. 8 is another block diagram a circuit for incorporating increased resolution of fixed-point representation of numerical values with legacy circuitry, according to some embodiments.

FIG. 9 is a table of modulation and coding schemes for wireless networking, according to some embodiments.

FIG. 10 is a table of modulation and coding schemes for wireless networking with additional schemes having bit transfer rates that are between coding schemes from FIG. 9, according to some embodiments.

FIG. 11 is a block diagram depicting a circuit for incorporating modulation and coding schemes labeled numerical values between existing modulation and coding scheme labels, according to some embodiments.

FIG. 12 is a block diagram depicting a circuit for further increasing the resolution of the numerical values used to label modulation and coding schemes, according to some embodiments.

FIG. 13 is a flow diagram for computing an output for a fixed-point value input with increased resolution, according to some embodiments.

FIG. 14 is a flow diagram for computing an output for a fixed-point value input for which the resolution has been increased twice, according to some embodiments.

DETAILED DESCRIPTION

The following IEEE standard(s), including any draft versions of such standard(s), are hereby incorporated herein by reference in their entirety and are made part of the present disclosure for all purposes: WiFi Alliance standards and IEEE 802.11 standards including but not limited to IEEE 802.11a™, IEEE 802.11b™, IEEE 802.11 g™, IEEE P802.11n™; IEEE P802.11ac™; and IEEE P802.11be™ through IEEE P802.11bn™ standards. Although this disclosure can reference aspects of these standard(s), the disclosure is in no way limited by these standard(s).

Current fixed-point formats use a fractional component (e.g., the binary digits indicating a negative power of two) that is positioned in the lowest bit index (e.g., least significant bit of the byte). For example, in an unsigned Q7.1 fixed-point format, bits 1-7 may be used to represent numbers between 0 and 127 and bit 0 may be used to represent 0.5. Q7.1 can represent numbers between 0 and 127.5 with resolution of 0.5. In some applications, more significant bits may not be used. For example, to represent numbers between 0-50 with resolution of 0.5 Q7.1 format may be used, but the last bit will always be '0'. In application specific circuitry, full bytes (of 8 bits) need not be used and the circuit may only provide the required amount of data lines (e.g., circuit traces, etc.).

If a new application for a similar circuit requires higher resolution, a bit must be inserted to the right of the least significant bit in the Q fixed-point format. However, circuits used for processing the previous (e.g., lower resolution) fixed-point format may not function appropriately with the inserted bit. Hardware and/or software modifications to use the new (e.g., higher resolution) fixed-point format may be expensive, error-prone, and lead to circuitry that is not backwards compatible with the previous numerical format. Systems and methods use a fixed point-format (e.g., with higher resolution) that is less susceptible to errors, is less expensive and is backwards compatible with the previous numerical format in some embodiments.

The present disclosure provides a fixed-point format that is scalable (denoted with B); that is, the fixed-point format allows resolution to be increased while providing backwards compatibility without modifying legacy circuitry in some embodiments. Advantageously, new products with higher resolution can be released with less development time in some embodiments. Scalability is achieved by positioning the fractional component of the fixed-point format in bits with higher indices relative to the integer component, with the higher indices representing smaller fractional values (e.g., powers of two with larger fractional numbers) in some embodiments. If the resolution of a number using the fixed-point format described herein is to be increased, an additional bit is used with a higher bit index than the previous highest resolution bit (e.g., least significant bit).

The present disclosure can be implemented for any existing system currently using unsigned integers, because unsigned integer format may be the same as the Q fixed-point format (e.g., Q8.0 or Q16.0) and the B fixed-point format in some embodiments. (For the fixed-point encodings Xm.n the letter [e.g., X] represents the format type, the first number [e.g., m] represents the number of bits used to represent non-negative powers of two or the integer component, and the second number [e.g., n] represents the number of bits used to represent the fractional component or negative powers of two in some embodiments.) For example, integer values using an unsigned 8-bit integer (e.g., uint8) that are between 0 and 31 can be converted to a B6.1 or a B6.2 format without changing any of the existing circuitry by the methods described herein.

One application of the B fixed-point format is in the representation of modulation and coding schemes. Modulation and coding schemes in the Wi-fi standard are currently represented by integers. However, future updates may include additional modulation and coding schemes that have effective bit transfer rates (e.g., effective bits transferred per transmitted symbol) that are between existing modulation and coding schemes. The B fixed-point format would allow the modulation and coding schemes to be represented by a numerical value for which the effective bit transfer rate is monotonically increasing with respect to the value for the modulation and coding scheme.

Some embodiments of the present disclosure relate to a device including one or more circuits configured to perform operations. The operations include generating a second binary encoded number by removing a first bit from a first binary encoded number in a fixed-point format. The operations also include generating a first output based on the first binary encoded number. The operations also include generating a second output based on the second binary encoded number and selecting the first output or the second output based on the first bit.

In some embodiments, the second binary encoded number has a lower resolution than the first binary encoded number.

A binary encoded number refers to any sequence of the symbols '1' and '0' (or 'high' and 'low' levels; or 'true' and 'false' etc.) used to represent a number in some embodiments. For example, a binary encoded number may refer to the sequence '00000101' to represent the integer 5 (e.g., as an unsigned integer) or '00011001' to represent 6.25 (e.g., as a Q6.2 fixed-point number). A fixed-point format refers to a class of binary encodings for numbers wherein a particular position in the binary sequence always has the same value in some embodiments. For example, a fixed-point format may refer to a Q6.2 format or a Q7.1 format. In Q7.1 fixed-point format, bit zero (e.g., index zero) always represents 0.5 and bit 7 (e.g., the last index of the byte) always represents 64. A lower resolution number (e.g., a number of a decreased resolution) refers to a value for which the least significant bit digit represents a larger amount compared to another number in some embodiments. For example, a Q6.1 representation has a decreased resolution compared to a Q6.2 resolution. In some embodiments, the number having the lower resolution may be referred to as a low-resolution number when defined relative to another number, for example, given a Q7.1 representation and a Q6.2 resolution the Q7.1 representation is low-resolution because it has fewer fractional bits (e.g., one fractional bit and providing resolution of 0.5) than the Q6.2 representation (e.g., having two fractional bits and providing resolution of 0.25).

A bit refers to a single digit of a binary encoded number in some embodiments. For example, a bit may refer to a position for a '1' or '0'. A byte refers to 8 bits stored in sequence in some embodiments. For example, a byte may refer to the sequence '00000101.' At least a portion of one or more bytes refers to any number of bits from one or more bytes keeping the original order in some embodiments. For example, at least a portion of a one or more bytes may refer to '0101' or '01 00000101.'

In some embodiments, the second output is a legacy output (e.g., calculated using a previous version of a circuit or code). A legacy output refers to an output of a circuit or software previously used (e.g., prior to an update) or that could have been used to process inputs of a previous revision in some embodiments. For example, a legacy output may refer to an output from a circuit that operates on lower-resolution input (e.g., from prior to upgrading a device to support a higher-resolution). In some embodiments, the first output is a contemporary output. A contemporary output refers to an output of a circuit for processing inputs using a format of a current revision in some embodiments. For example, a contemporary output may refer to an output from a circuit that operates on a higher-resolution input and/or outputs from a circuit for processing upgraded inputs.

In some embodiments, the first bit is a least significant digit of the first binary encoded number and a most significant bit of a portion of one or more bytes representing the first binary encoded number.

A least significant digit of a binary encoded number refers to the digit that contributes the least to the number's overall value in some embodiments. For example, a least significant digit may refer to bit 0 of a Q5.3 encoded number, which represents a value of 0.125 or a least significant digit may refer to bit 5 of a B4.2 number, which represents a value of 0.25. A most significant bit of a portion of one or more bytes refers to the bit location that would represent the largest value in an integer format in some embodiments. For example, the most significant portion of one or more bytes may refer to bit 7 for an unsigned 8-bit integer or the largest index of any bit within a portion of one or more bytes.

In some embodiments, the first binary encoded number represents a modulation and coding scheme.

In some embodiments, the first binary encoded number is one of a plurality of binary encoded numbers and the modulation and coding scheme is one of a plurality of modulation and coding schemes and respective effective data transfer rates of the plurality of modulation and coding schemes have a monotonic relationship with the plurality of binary encoded numbers.

In some embodiments, the first output and the second output include a modulation type and a coding rate, and the operations also include transmitting or receiving a signal using the modulation type and the coding rate.

A modulation and coding scheme refers to a modulation type and a coding rate in some embodiments. For example, a modulation and coding scheme may refer to a 16-quadrature amplitude modulation (QAM) with a coding rate of ¾. The modulation type refers to a relation between a sequence of binary digits (e.g., a symbol) and a magnitude and phase of a transmitted signal (e.g., as on a constellation diagram) in some embodiments. For example, the modulation type may refer to binary phase shift keying (BPSK), 16 QAM, or 256 QAM. The coding rate refers to the fraction of data transmitted that is not redundant (e.g., not used for forward error correction) in some embodiments. For example, a coding rate may refer to a 3/4 coding rate indicating that 25% of the transmitted symbols are redundant and used to detect transmission errors (e.g., 75% is used to transmit data).

An effective data transfer rate refers to the information content that can be delivered within a specific time over the communication channel in some embodiments. For example, an effective data transfer rate may refer to bits per second or bits per sample. Bits per second and bits per sample are related by the length of time a single symbol is transmitted (e.g. 12.8 $\mu$s) which may also be related to the signal bandwidth. A monotonic relationship refers to a function, mapping, or other relationship for which the gradient only takes one sign (e.g., non-negative or non-positive gradients) in some embodiments. For example, a monotonic relationship may refer to a monotonically increasing function such that if the input (e.g., the domain of the function) increases the output (e.g., the codomain) must not decrease, or a monotonically decreasing function such that if the input increases the output must not increase.

In some embodiments, an integer part of the first binary encoded number representing non-negative powers of two is stored in less significant bits of a portion of one or more bytes representing the first binary encoded number than a fractional part of the first binary encoded number representing negative powers of two.

A non-negative power of two refers to a number that can be written in the form of $2^n$ where n is a non-negative number in some embodiments. For example, a non-negative power of two may refer to the integers 1, 2, 4, 8 16, etc. and may be represented by a symbol in a certain location of a binary sequence. A negative power of two refers to a number that can be written in the form of $2^n$ where n is a negative number in some embodiments. For example, a negative power of two may refer to the fractions 1/2, 1/4, 1/8, 1/16, etc. and may be represented by a symbol in a certain location of a binary sequence. The integer part of a binary encoded number refers to the position in the binary sequence that represents non-negative powers of two in some embodiments. The fractional part of a binary encoded number refers to the position in the binary sequence that represents negative powers of two in some embodiments.

In some embodiments, successively less significant digits of the fractional part of the first binary encoded number are stored in successively more significant bits.

In some embodiments, the operations also include reordering digits of the first binary encoded number so that successively more significant digits of the first binary encoded number are stored in successively more significant bits of the portion of the one or more bytes prior to arithmetic operations.

In some embodiments, the operations also include removing a second bit from a third binary encoded number to generate the first binary encoded number. The second bit represents a second digit of the third binary encoded number that is less significant than a first digit represented by the first bit and the second bit is stored in a more significant location of one or more bytes representing the third binary encoded number. The operations also include generating a third output based on the third binary encoded number and selecting (i) the third output or (ii) the selecting of the first output or the second output based on the second bit.

In some embodiments, the third binary encoded number is a high-resolution number or a number of higher resolution. A high-resolution number refers to a value has several fractional digits in a fixed-point format in some embodiments. For example, a high-resolution number may refer to a number represented in Q4.2 or in Q5.3. High-resolution may be defined relative to another number, for example, given a Q7.1 representation and a Q6.2 resolution the Q6.2 representation is high-resolution because it has more fractional bits (e.g., two fractional bits providing resolution of 0.25) than the Q7.1 representation (e.g., having one fractional bit and providing resolution of 0.5).

Some embodiments of the present disclosure relate to a method. The method includes generating a second binary encoded number by removing a first bit from a first binary encoded number in a fixed-point format. The method also includes generating a second output based on the second binary encoded number. The method also include also include generating a first output based on the first bit and the second output and selecting the first output or the second output based on the first bit.

In some embodiments, the first bit is a least significant digit of the first binary encoded number and a most significant bit of a portion of one or more bytes representing the first binary encoded number.

In some embodiments, the first binary encoded number is one of a plurality of binary encoded numbers representing a plurality of modulation and coding schemes and respective effective data transfer rates of the plurality of modulation and coding schemes have a monotonic relationship with the plurality of binary encoded numbers.

In some embodiments, the first output and the second output include a modulation type and a coding rate and the method also includes transmitting or receiving a signal using the modulation type and the coding rate.

In some embodiments, an integer part of the first binary encoded number representing non-negative powers of two is stored in less significant bits of a portion of one or more bytes representing the first binary encoded number than a fractional part of the first binary encoded number representing negative powers of two.

In some embodiments, successively less significant digits of the fractional part of the first binary encoded number are stored in successively more significant bits.

In some embodiments, the method also includes reordering digits of the first binary encoded number so that successively more significant digits of the first binary encoded number are stored in successively more significant bits of the portion of the one or more bytes prior to arithmetic operations.

In some embodiments, the method also includes removing a second bit from a third binary encoded number to generate the first binary encoded number. The second bit represents a second digit of the third binary encoded number that is less significant than a first digit represented by the first bit and the second bit is stored in a more significant location of one or more bytes representing the third binary encoded number. The method also includes generating a third output based on the third binary encoded number and selecting (i) the third output or (ii) the selecting of the first output or the second output based on the second bit.

Some embodiments of the present disclosure relate to a device including a separation circuit configured to separate a first binary encoded number in a fixed-point format into one or more first bits and a second binary encoded number. The first binary encoded number is represented by at least a portion of one or more bytes and the one or more first bits include a least significant digit of the first binary encoded number and include a most significant bit of the portion of the one or more bytes. The device also includes a first processing circuit configured to generate a first output based on the first binary encoded number. The device also includes a second processing circuit configured to generate a second output based on the second binary encoded number. The device also includes a selection circuit configured to select the first output or the second output based on the one or more first bits.

Separating a binary encoded number refers to rerouting one or more bits from the binary encoded number to another storage in some embodiments. For example, bit four of a B4.1 fixed-point number (e.g., representing 0.5) may be removed leaving an integer (e.g., B4.0 or Q4.0).

In some embodiments, the first binary encoded number represents a modulation and coding scheme and the first output and the second output both include at least one of a modulation type or a coding rate. The device also includes at least one of a transmission circuit configured to transmit a first signal using the modulation type or the coding rate or a reception circuit configured to receive a second signal using the modulation type or the coding rate.

**Communications Network**

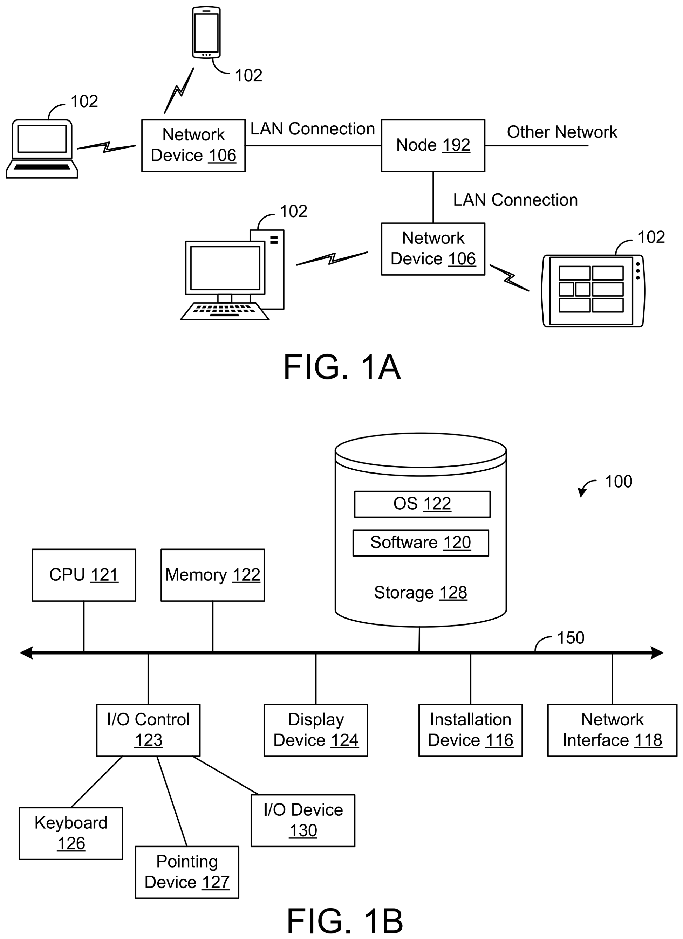

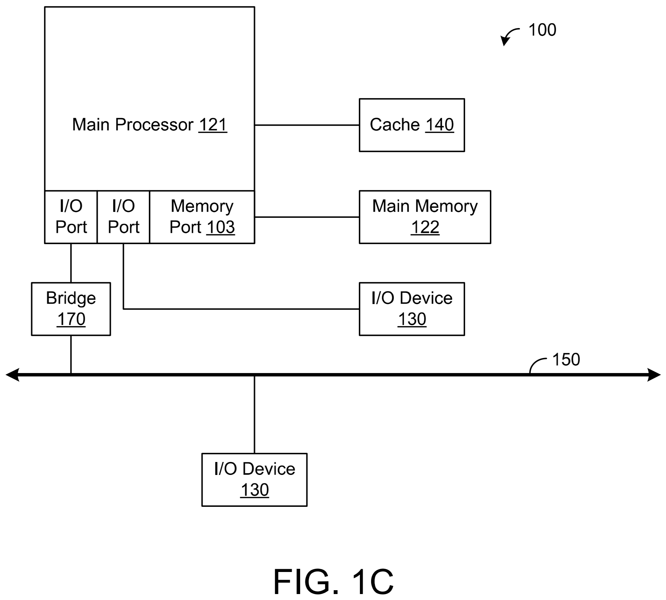

Prior to discussing certain embodiments, it can be helpful to describe aspects of the operating environment as well as associated system components (e.g., hardware elements) in connection with the methods and systems described herein. Referring to FIG. 1A, an embodiment of a network environment is depicted. In brief overview, the network environment includes a wireless communication system that includes one or more access points (APs) or network devices 106, one or more stations or wireless communication devices 102 and a network hardware component or network hardware 192. The wireless communication devices 102 can, for example, include laptop computers, tablets, personal computers, and/or cellular telephone devices. The details of an embodiment of each station or wireless communication device 102 and AP or network device 106 are described in greater detail with reference to FIGS. 1B and 1C. The network environment can be an ad hoc network environment, an infrastructure wireless network environment, a subnet environment, etc. in one embodiment. The network devices 106 or APs can be operably coupled to the network hardware 192 via local area network connections. Network devices 106 are 5G base stations in some embodiments. The network hardware 192, which can include a router, gateway, switch, bridge, modem, system controller, appliance, etc., can provide a local area network connection for the communication system. Each of the network devices 106 or APs can have an associated antenna or an antenna array to communicate with the wireless communication devices in its area. The wireless communication devices 102 can register with a particular network device 106 or AP to receive services from the communication system (e.g., via a SU-MIMO or MU-MIMO configuration). For direct connections (e.g., point-to-point communications), some wireless communication devices can communicate directly via an allocated channel and communications protocol. Some of the wireless communication devices 102 can be mobile or relatively static with respect to network device 106 or AP.

In some embodiments, a network device 106 or AP includes a device or module (including a combination of hardware and software) that allows wireless communication devices 102 to connect to a wired network using wireless-fidelity (WiFi), or other standards. A network device 106 or AP can sometimes be referred to as a wireless access point (WAP). A network device 106 or AP can be implemented (e.g., configured, designed and/or built) for operating in a wireless local area network (WLAN). A network device 106 or AP can connect to a router (e.g., via a wired network) as a standalone device in some embodiments. In other embodiments, network device 106 or AP can be a component of a router. Network device 106 or AP can provide multiple devices access to a network. Network device 106 or AP can, for example, connect to a wired Ethernet connection and provide wireless connections using radio frequency links for other devices 102 to utilize that wired connection. A network device 106 or AP can be implemented to support a standard for sending and receiving data using one or more radio frequencies. Those standards, and the frequencies they use can be defined by the IEEE (e.g., IEEE 802.11 standards). A network device 106 or AP can be configured and/or used to support public Internet hotspots, and/or on a network to extend the network's Wi-Fi signal range.

In some embodiments, the access points or network devices 106 can be used for (e.g., in-home, in-vehicle, or in-building) wireless networks (e.g., IEEE 802.11, Bluetooth, ZigBee, any other type of radio frequency based network protocol and/or variations thereof). Each of the wireless communication devices 102 can include a built-in radio and/or is coupled to a radio. Such wireless communication devices 102 and/or access points or network devices 106 can operate in accordance with the various aspects of the disclosure as presented herein to enhance performance, reduce costs and/or size, and/or enhance broadband applications. Each wireless communication device 102 can have the capacity to function as a client node seeking access to resources (e.g., data, and connection to networked nodes such as servers) via one or more access points or network devices 106.

The network connections can include any type and/or form of network and can include any of the following: a point-to-point network, a broadcast network, a telecommunications network, a data communication network, a computer network. The topology of the network can be a bus, star, or ring network topology. The network can be of any such network topology as known to those ordinarily skilled in the art capable of supporting the operations described herein. In some embodiments, different types of data can be transmitted via different protocols. In other embodiments, the same types of data can be transmitted via different protocols.

The communications device(s) 102 and access point(s) or network devices 106 can be deployed as and/or executed on any type and form of computing device, such as a computer, network device or appliance capable of communicating on any type and form of network and performing the operations described herein. FIGS. 1B and 1C depict block diagrams of a computing device 100 useful for practicing an embodiment of the wireless communication devices 102 or network device 106. As shown in FIGS. 1B and 1C, each computing device 100 includes a processor 121 (e.g., central processing unit), and a main memory unit 122. As shown in FIG. 1B, a computing device 100 can include a storage device 128, an installation device 116, a network interface 118, an I/O controller 123, display devices 124a-124n, a keyboard 126 and a pointing device 127, such as a mouse. The storage device 128 can include an operating system and/or software. As shown in FIG. 1C, each computing device 100 can also include additional optional elements, such as a memory port 103, a bridge 170, one or more input/output devices 130a-130n, and a cache memory 140 in communication with the central processing unit or processor 121.

The central processing unit or processor 121 is any logic circuitry that responds to and processes instructions fetched from the main memory unit 122. In many embodiments, the central processing unit or processor 121 is provided by a microprocessor unit, such as: those manufactured by Intel Corporation of Santa Clara, California; those manufactured by International Business Machines of White Plains, New York; or those manufactured by Advanced Micro Devices of Sunnyvale, California. The computing device 100 can be based on any of these processors, or any other processor capable of operating as described herein.

Main memory unit 122 can be one or more memory chips capable of storing data and allowing any storage location to be directly accessed by the microprocessor or processor 121, such as any type or variant of Static random access memory (SRAM), Dynamic random access memory (DRAM), Ferroelectric RAM (FRAM), NAND Flash, NOR Flash and Solid State Drives (SSD). The main memory unit 122 can be based on any of the above described memory chips, or any other available memory chips capable of operating as described herein. In the embodiment shown in FIG. 1B, the processor 121 communicates with main memory unit 122 via a system bus 150 (described in more detail below). FIG. 1C depicts an embodiment of a computing device 100 in which the processor communicates directly with main memory unit 122 via a memory port 103. For example, in FIG. 1C the main memory unit 122 can be DRDRAM.

FIG. 1C depicts an embodiment in which the main processor 121 communicates directly with cache memory 140 via a secondary bus, sometimes referred to as a backside bus. In other embodiments, the main processor 121 communicates with cache memory 140 using the system bus 150. Cache memory 140 typically has a faster response time than main memory unit 122 and is provided by, for example, SRAM, BSRAM, or EDRAM. In the embodiment shown in FIG. 1C, the processor 121 communicates with various I/O devices 130 via a local system bus 150. Various buses can be used to connect the central processing unit or processor 121 to any of the I/O devices 130, for example, a VESA VL bus, an ISA bus, an EISA bus, a MicroChannel Architecture (MCA) bus, a PCI bus, a PCI-X bus, a PCI-Express bus, or a NuBus. For embodiments in which the I/O device is a video display 124, the processor 121 can use an Advanced Graphics Port (AGP) to communicate with the display 124. FIG. 1C depicts an embodiment of a computer or computer system 100 in which the main processor 121 can communicate directly with I/O device 130b, for example via HYPERTRANSPORT, RAPIDIO, or INFINIBAND communications technology. FIG. 1C also depicts an embodiment in which local busses and direct communication are mixed: the processor 121 communicates with I/O device 130a using a local interconnect bus while communicating with I/O device 130b directly.

A wide variety of I/O devices 130a-130n can be present in the computing device 100. Input devices include keyboards, mice, trackpads, trackballs, microphones, dials, touch pads, touch screen, and drawing tablets. Output devices include video displays, speakers, inkjet printers, laser printers, projectors and dye-sublimation printers. The I/O devices can be controlled by an I/O controller 123 as shown in FIG. 1B. The I/O controller can control one or more I/O devices such as a keyboard 126 and a pointing device 127, e.g., a mouse or optical pen. Furthermore, an I/O device can also provide storage and/or an installation medium for the computing device 100. In still other embodiments, the computing device 100 can provide USB connections (not shown) to receive handheld USB storage devices such as the USB Flash Drive line of devices manufactured by Twintech Industry, Inc. of Los Alamitos, California.

Referring again to FIG. 1B, the computing device 100 can support any suitable installation device 116, such as a disk drive, a CD-ROM drive, a CD-R/RW drive, a DVD-ROM drive, a flash memory drive, tape drives of various formats, USB device, hard-drive, a network interface, or any other device suitable for installing software and programs. The computing device 100 can further include a storage device, such as one or more hard disk drives or redundant arrays of independent disks, for storing an operating system and other related software, and for storing application software programs such as any program or software 120 for implementing (e.g., configured and/or designed for) the systems and methods described herein. Optionally, any of the installation devices 116 could also be used as the storage device. Additionally, the operating system and the software can be run from a bootable medium.

Furthermore, the computing device 100 can include a network interface 118 to interface to a network through a variety of connections including, but not limited to, standard telephone lines, LAN or WAN links (e.g., 802.11, T1, T3, 56kb, X.25, SNA, DECNET), broadband connections (e.g., ISDN, Frame Relay, ATM, Gigabit Ethernet, Ethernet-over-SONET), wireless connections, or some combination of any or all of the above. Connections can be established using a variety of communication protocols (e.g., TCP/IP, IPX, SPX, NetBIOS, Ethernet, ARCNET, SONET, SDH, Fiber Distributed Data Interface (FDDI), RS232, IEEE 802.11, IEEE 802.11a, IEEE 802.11b, IEEE 802.11g, IEEE 802.11n, IEEE 802.11ac, IEEE 802.11ad, CDMA, GSM, WiMax and direct asynchronous connections). In one embodiment, the computing device 100 communicates with other computing devices 100' via any type and/or form of gateway or tunneling protocol such as Secure Socket Layer (SSL) or Transport Layer Security (TLS). The network interface 118 can include a built-in network adapter, network interface card, PCMCIA network card, card bus network adapter, wireless network adapter, USB network adapter, modem or any other device suitable for interfacing the computing device 100 to any type of network capable of communication and performing the operations described herein.

In some embodiments, the computing device 100 can include or be connected to one or more display devices 124a-124n. As such, any of the I/O devices 130a-130n and/or the I/O controller 123 can include any type and/or form of suitable hardware, software, or combination of hardware and software to support, enable or provide for the connection and use of the display device(s) 124a-124n by the computing device 100. For example, the computing device 100 can include any type and/or form of video adapter, video card, driver, and/or library to interface, communicate, connect or otherwise use the display device(s) 124a-124n. In one embodiment, a video adapter can include multiple connectors to interface to the display device(s) 124a-124n. In other embodiments, the computing device 100 can include multiple video adapters, with each video adapter connected to the display device(s) 124a-124n. In some embodiments, any portion of the operating system of the computing device 100 can be configured for using multiple display devices 124a-124n. In further embodiments, an I/O device 130 can be a bridge between the system bus 150 and an external communication bus, such as a USB bus, an Apple Desktop Bus, an RS-232 serial connection, a SCSI bus, a FireWire bus, a FireWire 800 bus, an Ethernet bus, an AppleTalk bus, a Gigabit Ethernet bus, an Asynchronous Transfer Mode bus, a FibreChannel bus, a fiber optic bus, a Serial Attached small computer system interface bus, a USB connection, or a HDMI bus.

A computing device 100 of the sort depicted in FIGS. 1B and 1C can operate under the control of an operating system, which controls scheduling of tasks and access to system resources. The computing device 100 can be running any operating system such as any of the versions of the MICROSOFT WINDOWS operating systems, the different releases of the Unix and Linux operating systems, any version of the MAC OS for Macintosh computers, any embedded operating system, any real-time operating system, any open source operating system, any proprietary operating system, any operating systems for mobile computing devices, or any other operating system capable of running on the computing device and performing the operations described herein. Typical operating systems include, but are not limited to: Android, produced by Google Inc.; WINDOWS 7, 8 and 10, produced by Microsoft Corporation of Redmond, Washington; MAC OS, produced by Apple Computer of Cupertino, California; WebOS, produced by Research In Motion (RIM); OS/2, produced by International Business Machines of Armonk, New York; and Linux, a freely-available operating system distributed by Caldera Corp. of Salt Lake City, Utah, or any type and/or form of a Unix operating system, among others.

The computer system or computing device 100 can be any workstation, telephone, desktop computer, laptop or notebook computer, server, handheld computer, mobile telephone or other portable telecommunications device, media playing device, a gaming system, mobile computing device, or any other type and/or form of computing, telecommunications or media device that is capable of communication. In some embodiments, the computing device 100 can have different processors, operating systems, and input devices consistent with the device. For example, in one embodiment, the computing device 100 is a smart phone, mobile device, tablet or personal digital assistant. Moreover, the computing device 100 can be any workstation, desktop computer, laptop or notebook computer, server, handheld computer, mobile telephone, any other computer, or other form of computing or telecommunications device that is capable of communication and that has sufficient processor power and memory capacity to perform the operations described herein.

**Circuit with Scalable Fixed-Point Numerical Format**

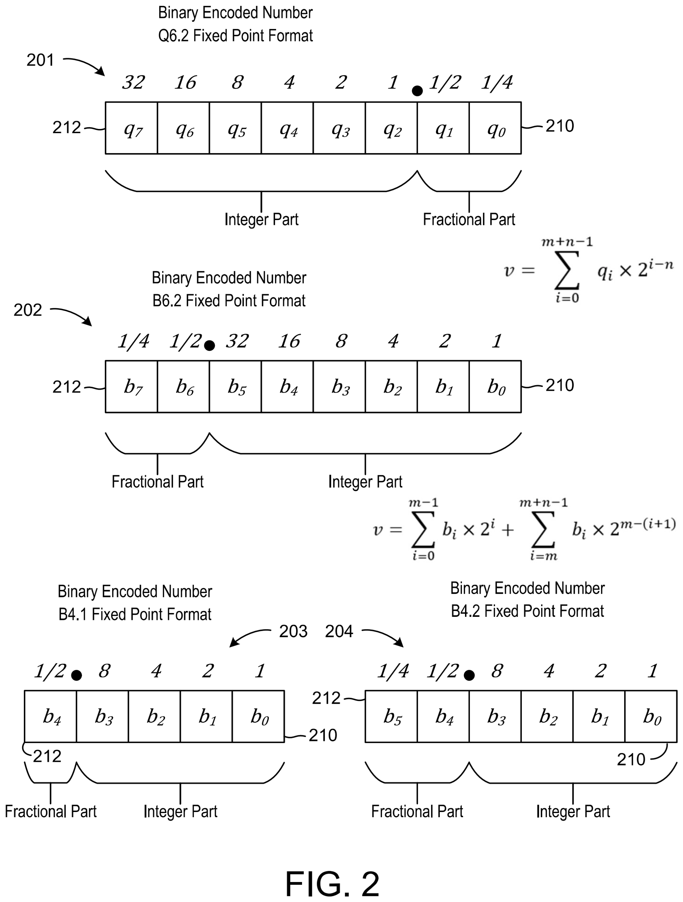

FIG. 2 illustrates various binary encodings of numbers that may be used in any of the systems and/or methods described herein. For example, any of the wireless communication devices 102, the network devices 106, and/or the computing device 100 (FIGS. 1A-C) may use the binary encodings described in FIG. 2. Other computing, sensing, or communication devices can use the binary encodings described herein.

A Q format binary encoded number 201 is shown in FIG. 2 according to some embodiments. The Q format binary encoded number 201 is shown in Q6.2 format having a 6-bit integer component and a 2-bit fractional component. The Q format binary encoded number 201 is shown to have 8-bits total and may be stored in one byte of the computing device 100.

The Q format binary encoded number 201 in Q6.2 is shown to have 8-bits represented by $q_0$-$q_7$. Q format is a fixed-point format and each of the bits $q_0$-$q_7$ represents a value based on the index (e.g., the position of the bit). If the bit is '1' (e.g., true, high, etc.), that bit contributes a specific amount to the overall value of the number. For example, in the Q6.2 format of the Q format binary encoded number 201 a '1' for bit $q_0$ indicates a contribution of 1/4, a '1' for bit $q_1$ indicates a contribution 1/2 as indicated by the numbers shown above the Q format binary encoded number 201 in FIG. 2. In general, the value of any Qm.n number can be found by:

$$v = \sum_{i=0}^{m+n-1} q_i \times 2^{i-n}$$

where $q_i$ is the value of the bit (e.g., 0 or 1), $m$ is the number of integer bits, and $n$ is the number of fractional bits. In the Q6.2 format of the Q format binary encoded number 201 the least significant bit 210 (e.g., bit $q_0$) is also the least significant digit of the binary encoded number and corresponds to the resolution of 1/4. The most significant bit 212 (e.g., bit $q_7$) is also the most significant digit of the binary encoded number and represents a value of 32. The Q6.2 format can represent numbers between 0 and 63.75 with a resolution of 0.25.

At least one disadvantage of the Q fixed-point format is that the resolution of the numbers (e.g., the value associated with the least significant bit) cannot be easily adjusted after the system is designed (e.g., circuits created, instruction code written, etc.). Increasing, the resolution may include adding a bit to the right of the least significant bit, for example, in an index -1 which may not be allowed. For example, consider the Q format binary encoded number 201 in Q6.2, if the resolution is increased to Q6.3 the value of each bit $q_0$-$q_7$ is decreased by a factor of 2. In the Q6.3 format $q_0$ is associated with a value of 1/8 and $q_1$ is associated with a value of 1/4, and so on. Because the values associated with each of the bits have changed, downstream circuits and/or software could additionally have to be changed leading to a costly redesign.

A different format of fixed-point binary encoding disclosed herein and referred to as B format may improve upon certain shortcomings of the Q format illustrated by Q format binary encoded number 201 in some embodiments. A B format binary encoded number 202 also has a 2-bit fractional component and a 6-bit integer component, in some embodiments, and is referred to as B6.2 herein (Bm.n where B represents the B format $m$ is the number of integer bits, and n is the number of fractional bits) in some embodiments. The B format is shown to include bits $b_0$-$b_7$ in some embodiments. The B format is also a fixed-point format, and as such each bit $b_0$-$b_7$, has a fixed value associated with the bit in some embodiments. One difference between the B format and the Q format is where the fractional component is stored. In the B format the fractional component is stored in the most significant bits (e.g., highest index) in memory. For example, the B format binary encoded number 202 shows the fractional bits stored in $b_6$ and $b_7$ and the integer component stored in $b_0$-$b_5$ in some embodiments.

In B format, the least significant bit 210 (e.g., the lowest index) may represent the integer value one, and the most significant bit 212 (e.g., the highest index) may represent the resolution (e.g., the least significant digit of the binary encoded number) as indicated by the numbers above the bits of the B format binary encoded number 202 in FIG. 2. The value of a binary encoded number in the B fixed-point format may be found by:

$$v = \sum_{i=0}^{m-1} b_i \times 2^i + \sum_{i=m}^{m+n-1} b_i \times 2^{m-(i+1)} = \sum_{i=0}^{m-1} b_i \times 2^i + \sum_{i=0}^{n-1} b_{m+i} \times 2^{-(i+1)}$$

where $b_i$ is the value of the bit (e.g., 0 or 1), $m$ is the number of integer bits, and $n$ is the number of fractional bits. In the B format, the most significant digit (e.g., representing the largest value) may not be stored in the most significant bit (e.g., having the highest index) in some embodiments. The most significant digit in the B fixed-point format may be stored in $b_{m-1}$. In the B fixed-point format, the least significant digit may be stored in the most significant bit $b_{m+n-1}$ in some embodiments. In some embodiments, a number represented in the B fixed-point format is converted to the Q fixed-point format before performing arithmetic operations (e.g., multiplication, addition, etc.). For example, digits of the number in the B fixed-point format may be reordered so that successively more significant digits stored in successively more significant bits (e.g., bits of higher indexes) as in the Q fixed-point format.

FIG. 2 shows two additional B format binary encoded numbers (e.g., B4.1 binary encoded number 203 and B4.2 binary encoded number 204) according to some embodiments. In some embodiments, a binary encoded number may not use all 8 bits of a byte. In some embodiments, a binary encoded number may use more than one byte. Thus, it is possible that while the least significant digit of a B fixed-point format binary encoded number may be stored in the most significant bit 212 (e.g., bit with the highest index) of the binary encoded number, the least significant digit may not be the highest index of a byte (e.g., if $m + n$ is not divisible by 8).

In B format, increasing resolution of the numbers represented in B format includes adding another bit in a bit position with an index one greater and representing a value equal to half of the previous resolution. For example, the resolution of the B4.1 binary encoded number 203 may be enhanced to 1/4 by augmenting the B4.1 binary encoded number 203 with $b_5$. Augmenting the B4.1 binary encoded number 203 with $b_5$ may have the effect of converting the B4.1 binary encoded number 203 into a B4.2 binary encoded number 204. Advantageously, the values associated with the bits existing in the B4.1 binary encoded number 203 (e.g., the bits $b_0$-$b_4$) do not change the value they represent when the resolution is increased (e.g., when the B4.1 binary encoded number 203 is converted to the B4.2 binary encoded number 204). Thus, the conversion may be performed with no change to existing (e.g., legacy) circuitry after the conversion using the circuits and methods described herein.

It is noted that the B format and the Q format are similar for integer resolution. For example, if there is no fractional component, the bits of the B format may represent the same integer values as the bits of the Q format. Systems or portions thereof with numbers represented as integers may be upgraded with higher resolution using the B fixed-point format without significant changes to existing systems.

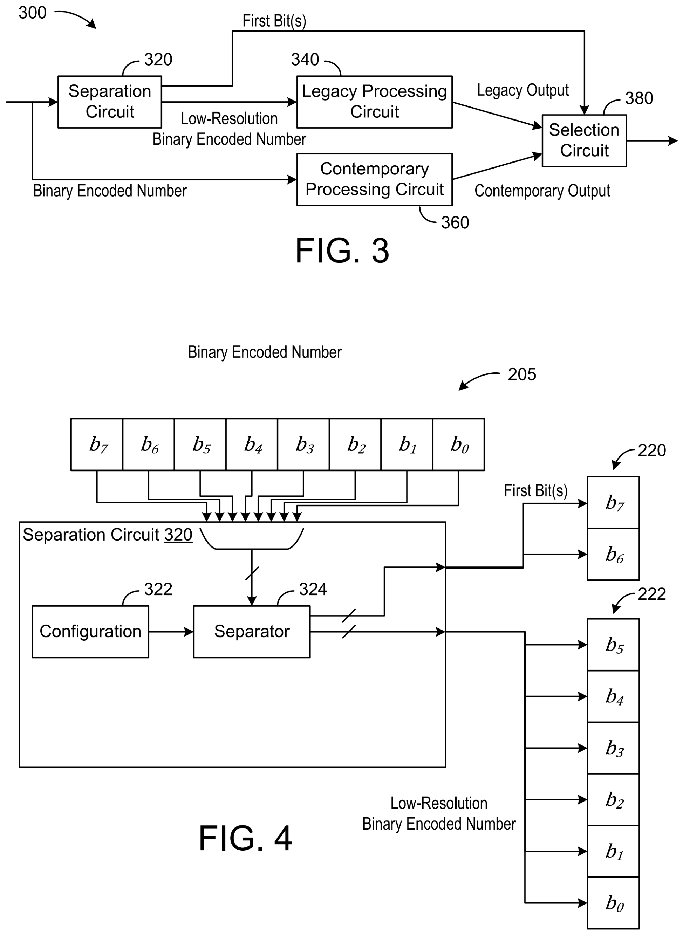

FIG. 3 is an illustrative block diagram of a resolution upgrade circuit 300 and its interconnection in a system (e.g., a device, apparatus, integrated circuit, etc.) configured to operate on number representations (e.g., binary encoded numbers) with increased resolution using the B fixed-point format, according to some embodiments. The system may be part of a wireless communications network for which a portion of the system has been upgraded for increased resolution. The circuitry, for example, may be implemented by any of the devices connected to or communicating with the networks shown in FIG. 1A. For example, the circuitry may be implemented within network device 106 and used to communicate with any user device 102. In some embodiments, the circuitry may be implemented using one or more memory devices storing instructions to be executed by one or more processors. In some embodiments, the circuitry is implemented using application specific integrated circuits (ASIC), digital signal processing (DSP) integrated circuits, or a system on a chip integrated circuit.

The processors may be a general purpose or specific purpose processors, an application specific integrated circuit (ASIC), artificial intelligence processors, one or more field programmable gate arrays (FPGAs), a DSP circuit, a group of processing components, or other suitable processing components. The processors may be configured to execute computer code and/or instructions stored in the memories or received from other computer readable media (e.g., CDROM, network storage, a remote server, etc.). The processors may be configured in various computer architectures, such as graphics processing units (GPUs), distributed computing architectures, cloud server architectures, client-server architectures, or various combinations thereof. One or more first processors can be implemented by a first device, such as an edge device, and one or more second processors can be implemented by a second device, such as a server or other device that is communicatively coupled with the first device and may have greater processor and/or memory resources.

The memories may include one or more devices (e.g., memory units, memory devices, storage devices, etc.) for storing data and/or computer code for completing and/or facilitating the various processes described in the present disclosure. The memories may include random access memory (RAM), read-only memory (ROM), hard drive storage, temporary storage, non-volatile memory, flash memory, optical memory, or any other suitable memory for storing software objects and/or computer instructions. The memories may include database components, object code components, script components, or any other type of information structure for supporting the various activities and information structures described in the present disclosure. The memories may be communicably connected to the processors and can include computer code for executing (e.g., by the processors) one or more processes described herein.

The resolution upgrade circuit 300 includes a separation circuit 320, a legacy processing circuit 340, a contemporary processing circuit 360, and a selection circuit 380 in some embodiments. The resolution upgrade circuit 300 may be configured separate (e.g., remove, reform, etc.) the appropriate number of bits from a B fixed-format binary encoded number to form a binary encoded number of the appropriate resolution for processing by previous generations of circuitry. The original input may be processed using circuits configured for the current code generation (e.g., higher resolution inputs) and the output of the processing circuits may then be selected based on the value of the bits that were separated from the input B fixed-format binary encoded number.

The separation circuit 320 may be configured to separate one or more bits from the binary encoded number input. The separation circuit 320 may separate the most significant bits (e.g., highest index) of the input byte or portion thereof. The separation circuit 320 may, by separating the bits with the highest index, decrease the resolution of the output binary encoded number if the input uses the B fixed-point format described herein. After the bits have been separated from the B fixed-point format input, the remaining lower-resolution binary encoded number may be processed by a circuit designed for the lower-resolution binary encoded number. As shown in FIG. 3, the lower-resolution binary encoded number may be output and applied as input by the legacy processing circuit 340, whereas the original binary encoded number input to the resolution upgrade circuit 300 may be processed by the contemporary processing circuit 360.

FIG. 4 shows a detailed block diagram of the separation circuit 320 according to some embodiments. The separation circuit 320 may include a configuration 322 and a separator 324. The configuration 322 may include parameters related to the bits to be separated from a binary encoded number input 205 for the current application of the separation circuit 320. The configuration 322, for example, may include parameters defining the format of the binary encoded number input 205 (e.g., B6.2, B4.4, etc.) and the format of the low-resolution output 222 (e.g., B6.0, B4.1, etc.). The input and output format may allow the separation circuit 320 to determine the correct number of bits to separate from the higher bit indexes of the binary encoded number input 205. Additionally or alternatively, the configuration 322 may store the number of bits to be separated.

The separator 324 may be configured to separate the bits of the binary encoded number input 205 at the location defined by the configuration 322. For example, the configuration 322 may indicate that the separation should include two bits with the highest index, occur between $b_5$ and $b_6$, and/or convert the binary encoded number input 205 (e.g., in B6.2 format) to the low-resolution output 222 (e.g., in B6.0 format). The separator 324 may include two outputs: a first output for the one or more first bits 220 that were separated from the binary encoded number input 205 and a second output for the low-resolution output 222.

Referring again to FIG 3. the low-resolution output 222 from the separation circuit 320 is applied to the legacy processing circuit 340 as input. The legacy processing circuit 340 may include any processing circuit that is configured to operate on the lower resolution of the low-resolution output 222. The legacy processing circuit 340 may be processing circuitry used prior to an upgrade to a higher resolution number format. For example, the legacy processing circuit 340 may be configured to process integer values and the resolution upgrade circuit 300 may be upgraded to support resolutions of 1/2 or 1/4. In some embodiments, the legacy processing circuit 340 generates a legacy output that can be passed out of the resolution upgrade circuit 300 for inputs that did not use the bits of higher resolution (e.g., the one or more first bits 220 that were separated are '0').

Using the legacy processing circuit 340 connected as shown in FIG. 3 allows the resolution upgrade circuit 300 to make use of the legacy processing circuit 340 without modification leading to faster development times. Additionally, the contemporary processing circuit 360 may only need to calculate an appropriate output when the output of the legacy processing circuit 340 that is not passed output of the resolution upgrade circuit 300, which could lead to design simplifications.

The contemporary processing circuit 360 may be configured to perform processing directly on the higher resolution input. For example, the contemporary processing circuit 360 may include circuits, instruction sets, etc. for generating an output for the upgraded or higher resolution fixed-point numerical formats. In some embodiments, the contemporary processing circuit 360 is configured to produce a contemporary output from the binary encoded number input that can be passed out of the resolution upgrade circuit 300, for example, if the one or more first bits 220 are not '0'.

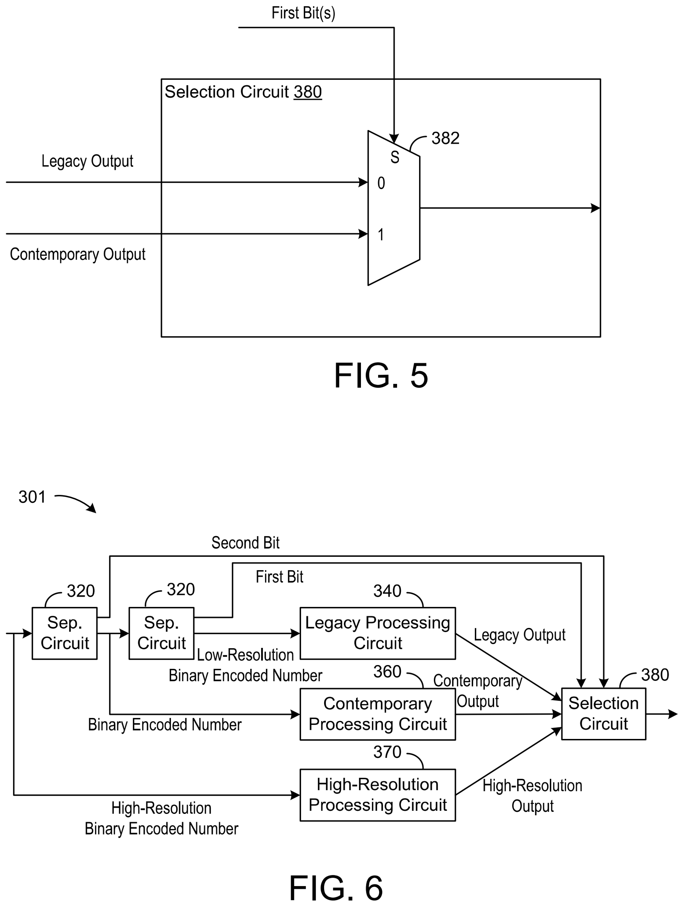

The selection circuit 380 may be configured to select between the contemporary output from the contemporary processing circuit 360 and the legacy output from the legacy processing circuit 340. FIG. 5 shows the selection circuit 380 according to some embodiments. For example, the selection circuit 380 of FIG. 5 may be used when the one or more first bits 220 include a single bit. The selection circuit 380 may include a multiplexer 382. The multiplexer 382 may select between the legacy output and the contemporary output based on the first bit. The multiplexer 382 may select the legacy output from the legacy processing circuit 340 if the first bit is '0' indicating that the input binary encoded number did not use the increased resolution and thus the legacy processing circuit 340 can process the input appropriately. Alternatively, the multiplexer 382 may select the contemporary output from the contemporary processing circuit 360 if the first bit is '1' indicating that the binary encoded number used the additional (e.g., upgraded resolution) and the contemporary processing circuit 360 may be used.

In some embodiments, the selection circuit 380 provides control signals back to the legacy processing circuit 340 and the contemporary processing circuit 360 (e.g., the processing circuits) causing their execution. The selection circuit 380 may only request execution of the processing circuit for which the output may eventually be used, for example, to reduce the number of computations that are performed, or the energy used (e.g., from switching loss, etc.) propagating signals through the unused processing circuit. Additionally or alternatively, the selection circuit 380 may block (e.g., prevent, etc.) the execution of the unused processing circuit. The selection circuit 380 may cause the instructions of the unused processing circuit to not be executed or the selection circuit 380 may prevent the input to the unused processing circuit from changing, thus preventing the propagation of any changes through the unused processing circuit.

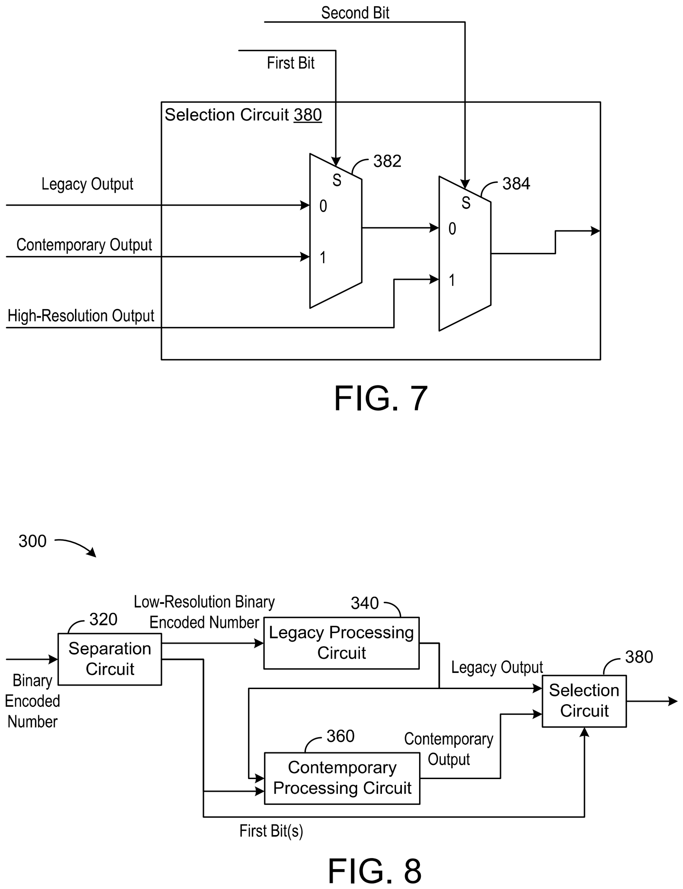

In some embodiments, the legacy processing circuit 340 and the contemporary processing circuit 360 are designed for the same generation of code or circuitry. The configuration of the resolution upgrade circuit 300 may be used to simplify the design of the processing circuits, for example, instead of a generational upgrade in resolution. A first processing circuit (e.g., the contemporary processing circuit 360) may be simplified because the outputs of the first processing circuit are disregarded when the first bit is zero and the selection circuit 380 selects the output of the first processing circuit. A second processing circuit (e.g., the legacy processing circuit 340) may be simplified because it operates on the outputs of lower resolution numbers. In addition, and as shown in FIG. 8, the first processing circuit may be configured to modify the output of the second processing circuit, allowing for additional simplification. Such uses for the circuit configurations described herein are within the scope of the present disclosure.

In some embodiments, a resolution upgrade circuit 300 can be nested within another resolution upgrade circuit 300. For example, if one upgrade has already been performed to increase the resolution of the binary encoded input, the entire resolution upgrade circuit 300 from the first upgrade may become the legacy processing circuit 340 for the second upgrade. FIG. 6 shows a nested resolution upgrade circuit 301 according to some embodiments. The nested resolution upgrade circuit 301 may include the multiple separation circuits 320 (e.g., an additional separation circuit 320 for each nesting layer), the legacy processing circuit 340, the contemporary processing circuit 360, a high-resolution processing circuit 370, and the selection circuit 380.

In some embodiments, each separation circuit 320 of the nested resolution upgrade circuit 301 may separate one bit from a high-resolution output. For example, each processing circuit may be configured to process numerical input using fixed-point encodings that provide twice the resolution (e.g., the resolution value divided by 2). The bits separated by the separation circuits 320 may be provided to (e.g., sent to, communicated to, applied to, etc.) the selection circuit 380 to allow a selection between the output from the legacy processing circuit 340, the contemporary processing circuit 360, or the high-resolution processing circuit 370. The selection circuit 380 may be configured as two selection circuits 380, for example, a first selection circuit 380 configured to select between the legacy output and the contemporary output and a second selection circuit 380 configured to select between the output of the first selection circuit 380 and the high-resolution output from the high-resolution processing circuit 370. Alternatively, the selection circuit 380 may be configured to select from the legacy output, contemporary output, and the high-resolution output based on both the first bit and the second bit from the separation circuits 320.

FIG. 7 shows a selection circuit 380 configured to select the legacy output, contemporary output, and the high-resolution output based on both the first bit and the second bit from the separation circuits 320, according to some embodiments. The selection circuit 380 may include two multiplexers (e.g., the multiplexer 382 and a multiplexer 384). The multiplexer 382 may be configured to select between the legacy output and the contemporary output based on the first bit and a second multiplexer 384 may be configured to select between the output of the multiplexer 382 and the high-resolution output based on the second bit. It is noted that the second bit may be the least significant bit and may be the bit with the highest index in the input byte. The second bit may refer to a second bit that was added during a resolution upgrade process. For example, the original circuitry may have been the legacy processing circuit 340 and configured only to process low-resolution binary encoded numbers (e.g., an integer). The first bit may have been added during a first resolution upgrade process (e.g., to provide resolution of 1/2), followed by a second upgrade process during which the second bit was added (e.g., to provide resolution of 1/4).

In some embodiments, the processing from the legacy processing circuit 340 can be reused by the contemporary processing circuit 360. The legacy output may be applied as an input to the contemporary processing circuit 360 and used to eliminate the need to repeat some circuitry that would be shared between the legacy processing circuit 340 and the contemporary processing circuit 360 in some embodiments. FIG. 8 shows the resolution upgrade circuit 300 according to some embodiments, where the output from the legacy processing circuit 340 is used by the contemporary processing circuit 360. In some embodiments, the binary encoded number input to the resolution upgrade circuit 300 is also provided to the contemporary processing circuit 360. Alternatively, the contemporary processing circuit 360 may be configured to modify the legacy output based on the first bit without using the whole binary encoded number. Advantageously, either configuration may reduce redundant processing performed by both the legacy processing circuit 340 and the contemporary processing circuit 360 thus saving computations and/or energy used by the resolution upgrade circuit 300.

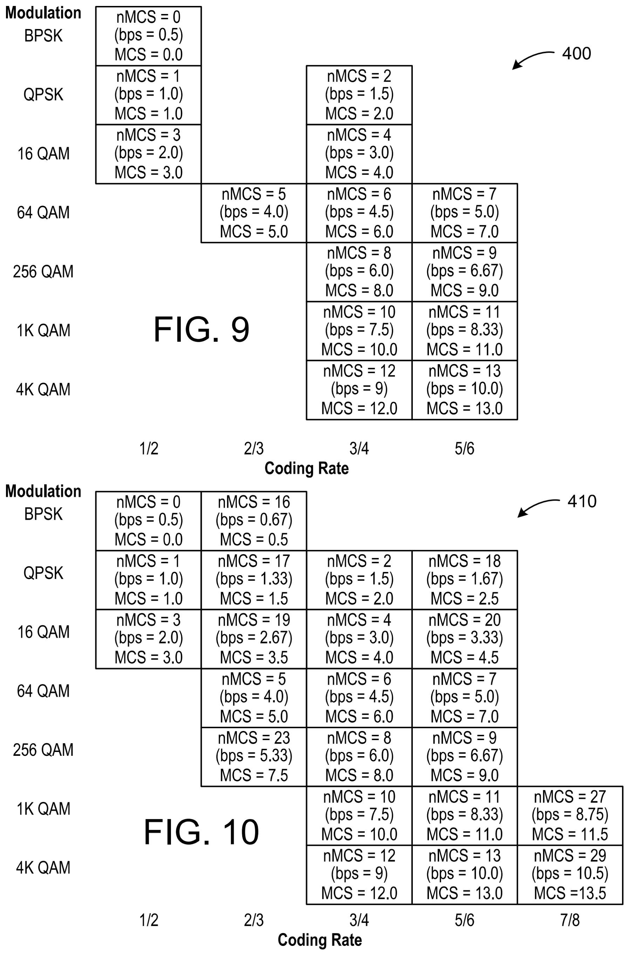

One application of the resolution upgrade circuit 300 may be the processing of the modulation and coding schemes used in standard wireless communication technologies. FIG. 9 shows a table 400 including modulation and coding schemes available in a first revision of the wireless communication standard (e.g., Wi-Fi 7) according to some embodiments. For each of the modulation and coding schemes the table 400 includes an nMCS (e.g., an integer representation of the binary sequence used to indicate the particular modulation and coding scheme), an MCS (e.g., the value of the binary sequence used to indicate the particular modulation and coding scheme using the B fixed-point format described herein), and the effective data transfer rate in bits per symbol (bps) (e.g., for one subcarrier frequency).

In a future revision of the wireless communication standard (e.g., Wi-Fi 8, or ultra high reliability (UHR)) more modulation and coding schemes may be added. FIG. 10 shows a table 410 including modulation and coding schemes in a potential future revision according to some embodiments. Some modulation and coding schemes in the table 410 provide an effective data transfer rate that is between the effective data transfer rate of two modulation and coding schemes that are already part of the standard (e.g., are in the table 400). For example, 256-QAM with a coding rate of 2/3 may provide an effective data transfer rate of 5.33 bps (e.g., 8-bits per symbol multiplied by the 2/3 coding rate). The effective data transfer rate of 5.33 bps is between the effective data transfer rates of 64-QAM with a coding rate of 5/6 (e.g., 5.0 bps) and 256-QAM with a coding rate of 3/4.

If an MCS number were assigned to new modulation and coding schemes sequentially, for example, by assigning the next available integer (e.g., 14) to 256-QAM with a 2/3 coding rate, the MCS number would no longer have a monotonic relationship with the effective data transfer rate. A greater MCS number may not indicate a higher capacity communication channel. Losing the monotonic relationship may cause issues with processing that depends on the MCS number. For example, if an MCS selection circuit was configured to always choose the greatest MCS number available and/or reliable, the circuit could select a suboptimal modulation and coding scheme even when faster modulation and coding schemes are available.

The MCS number may be represented in the B fixed-point format described herein. The MCS numbers in the table 400 which are integers between 0 and 16 may be represented in B4.0. To add MCS numbers that are between existing MCS numbers of the table 400 the resolution of the underlying numerical format for the MCS number may be increased. For example, the MCS number may be upgraded to an enhanced resolution using the B4.1 format. Alternatively, the MCS number may be upgraded to enhanced resolution using the B5.1 format to leave additional room for integer expansion. Advantageously, the B4.1 format may be used with the resolution upgrade circuit 300 in order to reuse any previously used MCS processing circuits.

The table 410 shows an MCS number for the modulation and coding schemes of the table 400 as well as additional modulation and coding schemes for a future revision of the wireless technology. The table 410 shows potential MCS numbers for the additional modulation and coding schemes that maintain a monotonic relationship with the effective data transfer rate. The table 410 also shows an nMCS number defined as the resulting integer if the MCS number represented using B4.1 was evaluated as an integer number (e.g., MCS of 7.5 = '10111' in B4.1 which if converted to an unsigned integer is 23).

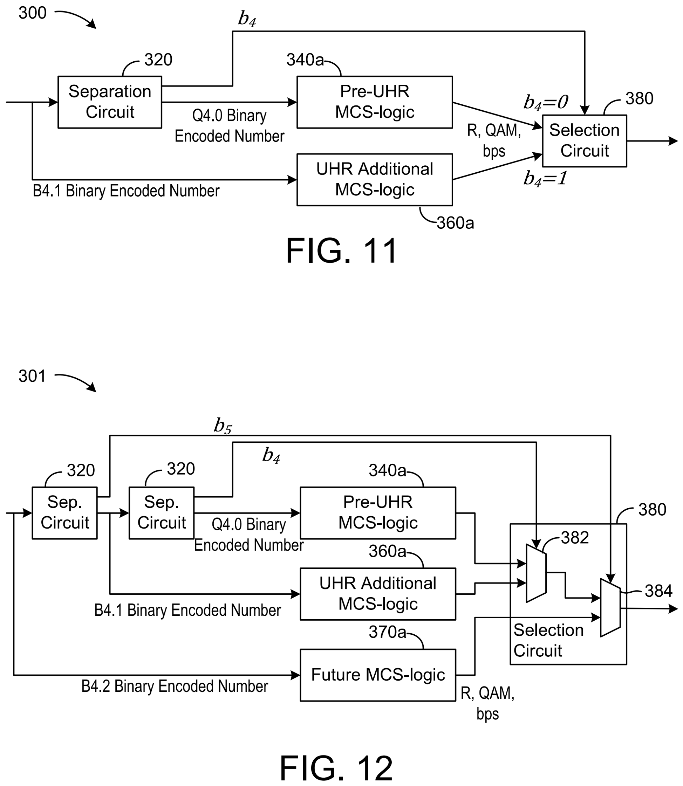

FIGS. 11 and 12 show embodiments of the resolution upgrade circuit 300 and the nested resolution upgrade circuit 301 that may be used to upgrade integer MCS numbers with increased resolution, according to some embodiments. The resolution upgrade circuits 300 and 301 in FIGS. 11 and 12 may be included in a wireless communication device configured to transmit and/or receive messages (e.g., by way of a transmission circuit and a reception circuit) according to the modulation and coding scheme represented by the MCS numbers. The resolution upgrade circuits 300 and 301 may determine the modulation and coding scheme (e.g., from a selected MCS number) and communicate the modulation and coding scheme to the transmission circuit and the reception circuit for appropriate decoding (or encoding) of the received (or transmitted) signal.

FIG. 11 shows the resolution upgrade circuit 300 used to upgrade integer MCS numbers to incorporate a numerical representation with a resolution of 1/2 according to some embodiments. For example, the the resolution upgrade circuit 300 in FIG. 11 may be configured to allow pre-UHR circuitry to be incorporated into the resolution upgrade circuit 300 to process MCS numbers that could be represented by the integer values used before the upgrade. Prior to the upgrade, a Q4.0 binary encoded number (e.g., same as an integer or B4.0) was applied as input to the Pre-UHR MCS-logic circuit 340a to generate an output indicating the modulation type (e.g., QAM), the coding rate (e.g., R), and the effective data transfer rate (e.g, bps). In order to represent the new 0.5 resolution MCS numbers in the table 410, the Pre-UHR MCS-logic circuit 340a may be incorporated into the resolution upgrade circuit 300 as an embodiment of the legacy processing circuit 340.

A B4.1 number may be used to represent the additional resolution of the MCS numbers of the table 410 by incorporating an additional bit $b_4$ (e.g., the most significant bit or highest index of the portion of the byte used to represent the input) to represent a value of 0.5. The B4.1 number may be input to a separation circuit 320 within which the first bit, $b_4$, may be separated from the integer component and passed to the selection circuit 380. The integer portion may be applied as input to the Pre-UHR MCS-logic circuit 340a to generate an output for R, QAM, and bps as if the resolution were not updated. The original B4.1 number input to the resolution upgrade circuit 300 may be applied as input to a UHR Additional MCS-logic circuit 360a (e.g., implementing the contemporary processing circuit 360) to generate an output for R, QAM, and bps for any inputs that use the enhanced resolution. The selection circuit 380 may then select the R, QAM, and bps from the Pre-UHR MCS-logic circuit 340a or the UHR Additional MCS-logic circuit 360a. If the first bit, $b_4$, is '0' indicating the increased resolution is not used and that the Pre-UHR MCS-logic circuit 340a is configured to calculate the appropriate output, the output from the Pre-UHR MCS-logic circuit 340a may be selected. If the first bit, $b_4$, is '1' indicating that the increase resolution is necessary and the UHR Additional MCS-logic circuit 360a is configured to calculate the appropriate output, the output from the UHR Additional MCS-logic circuit 360a may be selected.

To upgrade MCS number resolution it may be appropriate to use the configuration of the resolution upgrade circuit 300 shown in FIG. 8. The UHR Additional MCS-logic circuit 360a may be configured to adjust the legacy outputs of the R, QAM, and bps. For example, each of the modulation and coding schemes in table 410 that use the enhanced resolution bit, $b_4$, has a coding scheme that is shifted by one (e.g., from R = 1/2 to R = 2/3, from R = 3/4 to R = 4/5, etc.) relative to the modulation and coding scheme that does not used the enhanced resolution bit, $b_4$. The UHR Additional MCS-logic circuit 360a may be configured to shift the coding scheme output by the Pre-UHR MCS-logic circuit 340a when the first bit, $b_4$, is '1' rather than recoding the entire table, advantageously reducing the complexity (and thus cost, failure rate, etc.) of the resolution upgrade circuit 300 configured to enhance the resolution of an MCS number.

In some embodiments, more than one modulation and coding scheme have an effective data transfer rate that is between the effective data transfer rate of two of the modulation and coding schemes shown in the table 400. For example, if 256-QAM with a coding rate of 2/3 (e.g., with a bps of 5.33) and 64-QAM with a coding rate of 7/8 (e.g., with a bps of 5.875) are used, two MCS numbers may be placed between the MCS 7.0 and MCS 8.0 and a resolution of 0.25 may be appropriate. In some embodiments, the nested resolution upgrade circuit 301 may be used to enhance the resolution of the MCS numbering scheme to include a resolution of 0.25. It is contemplated that if the resolution is upgraded from integer resolution to a resolution of 0.25 at one time, the separation circuit 320 and the selection circuit 380 may be configured to process both the digits simultaneously. However, if the resolution is enhanced in stages (e.g., first upgrading to 0.5 resolution and later to 0.25 resolution) the nested configuration of the nested resolution upgrade circuit 301 may be appropriate.

FIG. 12 shows an implementation of the nested resolution upgrade circuit 301 wherein the Pre-UHR MCS-logic circuit 340a implements the legacy processing circuit 340, the UHR Additional MCS-logic circuit 360a implements the contemporary processing circuit 360 and is configured to process inputs with resolution of 0.5, and a future MCS-logic circuit 370a implements the high-resolution processing circuit 370. In some embodiments, a first separation circuit 320 may separate bit $b_5$ from the input to form a B4.1 binary encoded number for processing by the UHR Additional MCS-logic circuit 360a. A second separation circuit 320 may separate bit $b_4$ from the output of the first separation circuit 320 to generate the integer representation for the Pre-UHR MCS-logic circuit 340a. Additionally, the original B4.2 number may be input to the future MCS-logic circuit 370a. The selection circuit 380 may choose the appropriate output R, QAM, and bps from the processing circuits. For example, the bit $b_4$ may be used to select between the output from the Pre-UHR MCS-logic circuit 340a or the UHR Additional MCS-logic circuit 360a at the multiplexer 382 and the bit $b_5$ may be used to select between the output from output of the multiplexer 382 and the output from the future MCS-logic circuit 370a at the multiplexer 384.

## Operational Flow for Increasing Resolution for a Fixed-Point Numerical Format

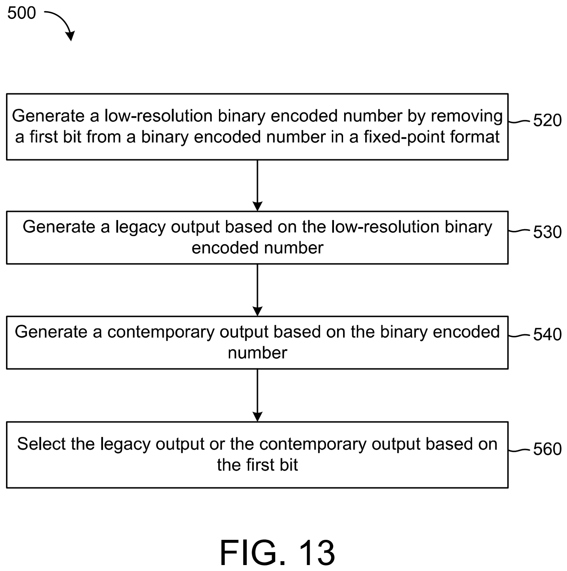

FIG. 13 is a flow of operations 500 for enhancing the resolution of numerical formats in a circuit without significant changes to existing circuits or code according to some embodiments. The flow of operations 500 may be performed by the resolution upgrade circuit 300 or the nested resolution upgrade circuit 301. For example, the flow of operations 500 may be used to generate the coding rate, modulation type, and effective data transfer rate for a wireless communication device that has been upgraded to use MCS numbers with a resolution of 0.5 (e.g., instead of integer numbers).

After performing the flow of operations 500, downstream operations may be unchanged (e.g., from prior to using enhanced resolution for one or more of the numerical values). For example, a device executing the flow of operations 500 to make use of MCS numbers with a resolution of 0.5 may use the coding rate, modulation type, and effective data transfer rate in a substantially similar way as the values were used with MCS numbers that are integers. As a transmitter, the device may generate an orthogonal frequency domain multiple access (OFDMA) communication signal according to the constellation diagram of the modulation type (e.g., determined using the flow of operations 500 and/or the resolution upgrade circuit 300), repeating the data at a frequency based on the coding rate (e.g., also determined using the flow of operations 500 and/or the resolution upgrade circuit 300), modulating the communication signal at the carrier frequency, and transmitting the modulated signal. Similarly, as a receiver the device may perform the flow of operations 500 to generate the modulation type and coding rate, decode a received signal according to the modulation type into binary symbols, and perform fault detection (e.g., for communication channel interference, etc.) at a frequency based on the coding rate. Additionally, the monotonic relationship between the MCS number and the effective data transfer rate may be maintained using the B4.1 fixed-point format allowing downstream optimizations to remain unchanged or similar.

The flow of operations 500 may include generating a low-resolution binary encoded number by removing a first bit from a binary encoded number in a fixed-point format in operation 520. The low-resolution binary encoded number may be in the B fixed-point format and the fractional components may be stored in the bit positions with a higher index. By removing the first bit of a binary encoded number in the B fixed-point format described herein, the resolution is multiplied (e.g., degraded) by a factor of two forming the low-resolution binary encoded number. In some embodiments, more than one bit is removed from the binary encoded number and the resolution is degraded by multiple factors of two.

The low-resolution binary encoded number output from the operation 520 may be used as input to subsequent operations for processing binary encoded numbers of lower resolution (e.g., operations from legacy code or prior to an upgrade to enhanced resolution). In some embodiments, for example, the binary encoded number represents an MCS number for a modulation and coding scheme that includes enhanced resolution of 0.5 in the B4.1 fixed-point format. The operation 520 may be used to remove the first bit to generate a B4.0 (e.g., or integer representation) numerical value that may be processed using previous instructions and/or circuitry configured to operate using the legacy (e.g., integer based MCS numbers). The separation circuit 320 may be configured to perform the operation 520, generating an output for the first bit (or all removed bits) and the remaining low-resolution binary encoded number as described previously.

The flow of operations 500 may include generating a legacy output based on the low-resolution binary encoded number in the operation 530. In some embodiments, the flow of operations 500 is performed after the resolution of a numerical value is enhanced (e.g., made smaller to form a high-resolution value). The operation 530 may be performed in a same or substantially similar method or procedure as prior to the enhanced resolution. Removing the first bit in the operation 520 allows the similar operations to be performed.

The operation 530 may be performed by the legacy processing circuit 340. In some embodiments, the binary encoded number represents an MCS number for a modulation and coding scheme that includes enhanced resolution of 0.5 in the B4.1 fixed-point format and the low-resolution number having the first bit removed is in B4.0 format (e.g., an integer). The modulation type, coding rate, and the effective data transfer rate may be found using the Pre-UHR MCS-logic circuit 340a for the low-resolution B4.0 format.

The flow of operations 500 may include generating a contemporary output based on the binary encoded number in operation 540. The operation 540 may include performing operations to process the binary encoded number. In some embodiments, the binary encoded number may represent a numerical value with enhanced resolution and the operation 530 may be modified in order to process values with enhanced resolution. In some embodiments, a number of the steps of the operation 530 may be reused to process the (higher resolution) binary encoded number. The operation 540 may process (e.g., adjust, modify, etc.) the output of the operation 530 using the first bit as input (e.g., using the embodiment of resolution upgrade circuit 300 shown in FIG. 8).

The operation 540 may be performed by the contemporary processing circuit 360 or, in embodiments where the binary encoded number represents an MCS number for a modulation and coding scheme, by the UHR Additional MCS-logic circuit 360a.

The flow of operations 500 may include selecting the legacy output or the contemporary output based on the first bit in the operation 560. For example, the operation 560 may be performed by the selection circuit 380 as described herein. If the first bit is '0', the enhanced resolution is not used, and the legacy output generated from the low-resolution binary encoded number in the operation 530 is appropriate to use. However, if the first bit is '1', then the contemporary output from the operation 540 is appropriate.

In some embodiments, the legacy output of the operation 530 and the contemporary output of the operation 540 are for the same generation of code and/or circuitry. The flow of operations 500 may be used to simplify the design of the operations to generate the specific output, for example, instead of a generational upgrade in resolution. A first output (e.g., the contemporary output of the operation 540) may be simplified because the first output is disregarded for certain values of the first bit in the operation 560. A second output (e.g., the legacy output of the operation 530) may be simplified because it operates on lower resolution numbers (e.g., with fewer bits). In addition, the operation 540 may modify the second output of the operation 530, allowing for additional simplification. Such uses for the flow of operations described herein are within the scope of the present disclosure.

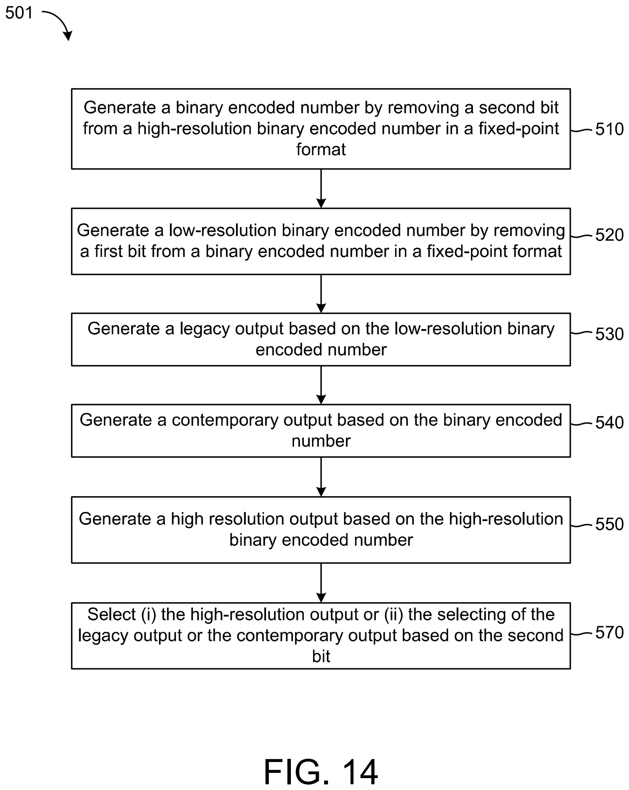

FIG. 14 is another flow of operations 501 for enhancing the resolution numerical formats in a circuit without significant changes to existing circuits or code according to some embodiments. The flow of operations 501 may be performed, for example, if the resolution of a numerical value has been previously enhanced (e.g., using the resolution upgrade circuit 300 and/or the flow of operations 500) and it is desired to enhance the resolution a second time. In some embodiments, the flow of operations 500 may be nested (e.g., recursed) each time the resolution of the numerical value is enhanced. Because of the nested configuration, many of the operations of the flow of operations 501 are similar to those of the flow of operations 500.

The flow of operations 501 may include generating a binary encoded number by removing a second bit from a high-resolution binary encoded number in a fixed-point format in operation 510. The operation 510 may be performed by a separation circuit 320. It is noted that while the bit removed in the operation 510 is referred to as the second bit, the second bit may be removed from the high-resolution binary encoded number prior to the first bit and may refer to the bit with the highest index of the byte or portion thereof representing the high-resolution binary encoded number. For example, the high-resolution binary encoded number may be in the B4.2 fixed point format. When the second bit (e.g., bit $b_5$) is removed, the result is a B4.1 fixed-point format value and when the first bit (e.g., bit $b_4$) is subsequently removed, the result is a B4.0 fixed-point format value.

The flow of operations 501 may include generating a low-resolution binary encoded number by removing a first bit from a binary encoded number in a fixed-point format in the operation 520, generating a legacy output based on the low-resolution binary encoded number in the operation 530, and generating a contemporary output based on the binary encoded number in the operation 540. These operations may be substantially similar to those in the flow of operations 500 and be performed by a second separation circuit 320, the legacy processing circuit 340 and the contemporary processing circuit 360 respectively.

The flow of operations 501 may include generating a high-resolution output based on the high-resolution binary encoded number in the operation 550. The operation 550 may include steps specific to processing the high-resolution binary encoded number. In some embodiments, for example, the high-resolution binary encoded number represents an MCS number for a modulation and coding scheme that includes enhanced resolution of 0.25 in the B4.2 fixed-point format and the operations may be performed by the future MCS-logic circuit 370a. The flow of operations 501 may include selecting (i) the high-resolution output or (ii) the selecting of the legacy output or the contemporary output based on the second bit in the operation 570.

After performing the flow of operations 501, downstream operations may be unchanged (e.g., from prior to enhancing the resolution for one or more of the numerical values). For example, a device executing the flow of operations 501 to make use of MCS numbers with a resolution of 0.25 may use the coding rate, modulation type, and effective data transfer rate in a substantially similar was as the values were used with MCS numbers that are integers. As a transmitter, the device may generate an orthogonal frequency domain multiple access (OFDMA) communication signal according to the constellation diagram of the modulation type (e.g., determined using the flow of operations 501 and/or the resolution upgrade circuit 301), repeating the data at a frequency based on the coding rate (e.g., also determined using the flow of operations 501 and/or the resolution upgrade circuit 301), modulating the communication signal at the carrier frequency, and transmitting the modulated signal. Similarly, as a receiver the device may perform the flow of operations 501 to generate the modulation type and coding rate, decode a received signal according to the modulation type into binary symbols, and perform fault detection (e.g., for communication channel interference, etc.) at a frequency based on the coding rate. Additionally, the monotonic relationship between the MCS number and the effective data transfer rate may be maintained using the B4.2 fixed-point format allowing downstream optimizations to remain unchanged or similar.

**Configuration of Exemplary Embodiments**

As utilized herein, the terms "approximately," "about," "substantially", and similar terms are intended to have a broad meaning in harmony with the common and accepted usage by those of ordinary skill in the art to which the subject matter of this disclosure pertains. It should be understood by those of skill in the art who review this disclosure that these terms are intended to allow a description of certain features described and claimed without restricting the scope of these features to the precise numerical ranges provided. Accordingly, these terms should be interpreted as indicating that insubstantial or inconsequential modifications or alterations of the subject matter described and claimed are considered to be within the scope of the disclosure as recited in the appended claims.

It should be noted that the term "exemplary" and variations thereof, as used herein to describe various embodiments, are intended to indicate that such embodiments are possible examples, representations, or illustrations of possible embodiments (and such terms are not intended to connote that such embodiments are necessarily extraordinary or superlative examples).

The construction and arrangement of the systems and methods as shown in the various exemplary embodiments are illustrative only. Although only a few embodiments have been described in detail in this disclosure, many modifications are possible (e.g., variations in port or destination quantity, data types, methods of reinsertion, reintroduction, etc., values of parameters, arrangements, etc.). For example, the position of elements may be reversed or otherwise varied, the connections between elements may be direct or indirect, such that there may be one or more intermediate elements connected in between, and the nature or number of discrete elements or positions may be altered or varied. Accordingly, all such modifications are intended to be included within the scope of the present disclosure. The order or sequence of any process or method steps may be varied or re-sequenced according to alternative embodiments. Other substitutions, modifications, changes, and omissions may be made in the design, operating conditions, and arrangement of the exemplary embodiments without departing from the scope of the present disclosure. For example, the embodiments of the present disclosure may be implemented by a single device and/or system or implemented by a combination of separate devices and/or systems.

The term "or," as used herein, is used in its inclusive sense (and not in its exclusive sense) so that when used to connect a list of elements, the term "or" means one, some, or all of the elements in the list. Conjunctive language such as the phrase "at least one of X, Y, and Z," unless specifically stated otherwise, is understood to convey that an element may be either X, Y, Z; X and Y; X and Z; Y and Z; or X, Y, and Z (i.e., any combination of X, Y, and Z). Thus, such conjunctive language is not generally intended to imply that certain embodiments require at least one of X, at least one of Y, and at least one of Z to each be present, unless otherwise indicated.

References herein to the positions of elements (i.e., "top," "bottom," "above," "below") are merely used to describe the orientation of various elements in the FIGURES. It should be noted that the orientation of various elements may differ according to other exemplary embodiments, and that such variations are intended to be encompassed by the present disclosure.

Although the figures show a specific order of method steps, the order of the steps may differ from what is depicted. Also two or more steps may be performed concurrently or with partial concurrence. Such variation will depend on the software and hardware systems chosen and on designer choice. All such variations are within the scope of the disclosure. Likewise, software implementations could be accomplished with standard programming techniques with rule-based logic and other logic to accomplish the various connection steps, processing steps, comparison steps, and decision steps.

The present disclosure contemplates methods, systems, and program products on any machine-readable media for accomplishing various operations. The embodiments of the present disclosure may be implemented using existing computer processors, or by a special purpose computer processor for an appropriate system, incorporated for this or another purpose, or by a hardwired system. Embodiments within the scope of the present disclosure include program products comprising machine-readable media for carrying or having machine-executable instructions or data structures stored thereon. Such machine-readable media can be any available media that can be accessed by a general purpose or special purpose computer or other machine with a processor. By way of example, such machine-readable media can comprise RAM, ROM, EPROM, EEPROM, CD-ROM or other optical disk storage, magnetic disk storage or other magnetic storage devices, or any other medium which can be used to carry or store desired program code in the form of machine-executable instructions or data structures and which can be accessed by a general purpose or special purpose computer (i.e., ASICs or FPGAs) or any other machine with a processor. Combinations of the above are also included within the scope of machine-readable media. Machine-executable instructions include, for example, instructions and data which cause a general purpose computer, special purpose computer, or special purpose processing machines to perform a certain function or group of functions.

**Claims**

1. A method comprising:

   generating a second binary encoded number by removing a first bit from a first binary encoded number in a fixed-point format;
   generating a first output based on the first binary encoded number;
   generating a second output based on the second binary encoded number; and
   selecting the first output or the second output based on the first bit.

2. The method of claim 1, wherein
   the second binary encoded number has a lower resolution than the first binary encoded number.

3. The method of claim 1 or 2, wherein
   the first bit is a least significant digit of the first binary encoded number and a most significant bit of a portion of one or more bytes representing the first binary encoded number.

4. The method of claim 3, wherein
   the first binary encoded number represents a modulation and coding scheme.

5. The method of claim 4, wherein
   the first binary encoded number is one of a plurality of binary encoded numbers and the modulation and coding scheme is one of a plurality of modulation and coding schemes and respective effective data transfer rates of the plurality of modulation and coding schemes have a monotonic relationship with the plurality of binary encoded numbers.

6. The method of claim 4 or 5, wherein:

   the first output and the second output comprise a modulation type and a coding rate; and
   the operations further comprise transmitting or receiving a signal using the modulation type and the coding rate.

7. The method of any one of the preceding claims, wherein
   an integer part of the first binary encoded number representing non-negative powers of two is stored in less significant bits of a portion of one or more bytes representing the first binary encoded number than a fractional part of the first binary encoded number representing negative powers of two.

8. The method of claim 7, wherein
   successively less significant digits of the fractional part of the first binary encoded number are stored in successively more significant bits.

9. The method of claim 8, the operations further comprising
   reordering digits of the first binary encoded number so that successively more significant digits of the first binary encoded number are stored in successively more significant bits of the portion of the one or more bytes prior to arithmetic operations.

10. The method of any one of the preceding claims, further comprising:

    removing a second bit from a third binary encoded number to generate the first binary encoded number, the second bit representing a second digit of the third binary encoded number that is less significant than a first digit represented by the first bit and the second bit stored in a more significant location of one or more bytes representing the third binary encoded number;
    generating a third output based on the third binary encoded number; and
    selecting (i) the third output or (ii) the selecting of the first output or the second output based on the second bit.

11. A device comprising one or more circuits configured to control and/or carry out a method as set forth in any one of the preceding claims.

12. A device comprising:

a separation circuit configured to separate a first binary encoded number in a fixed-point format into one or more first bits and a second binary encoded number, the first binary encoded number represented by at least a portion of one or more bytes and wherein the one or more first bits include a least significant digit of the first binary encoded number and include a most significant bit of the portion of the one or more bytes;

a first processing circuit configured to generate a first output based on the first binary encoded number;

a second processing circuit configured to generate a second output based on the second binary encoded number; and

a selection circuit configured to select the first output or the second output based on the one or more first bits.

13. The device of claim 12, wherein:

the first binary encoded number represents a modulation and coding scheme and the first output and the second output both comprise at least one of a modulation type or a coding rate; and

the device further comprises at least one of:

a transmission circuit configured to transmit a first signal using the modulation type or the coding rate; or

a reception circuit configured to receive a second signal using the modulation type or the coding rate.

FIG. 1A

FIG. 1B

19

100

Main Processor 121 — Cache 140

I/O Port | I/O Port | Memory Port 103 — Main Memory 122

Bridge 170

I/O Device 130

150

I/O Device 130

# FIG. 1C

Binary Encoded Number
Q6.2 Fixed Point Format

201

| 32 | 16 | 8 | 4 | 2 | 1 | • 1/2 | 1/4 |

212 —

| $q_7$ | $q_6$ | $q_5$ | $q_4$ | $q_3$ | $q_2$ | $q_1$ | $q_0$ |

— 210

Integer Part          Fractional Part

$$v = \sum_{i=0}^{m+n-1} q_i \times 2^{i-n}$$

Binary Encoded Number
B6.2 Fixed Point Format

202

| 1/4 | 1/2 • | 32 | 16 | 8 | 4 | 2 | 1 |

212 —

| $b_7$ | $b_6$ | $b_5$ | $b_4$ | $b_3$ | $b_2$ | $b_1$ | $b_0$ |

— 210

Fractional Part          Integer Part

$$v = \sum_{i=0}^{m-1} b_i \times 2^i + \sum_{i=m}^{m+n-1} b_i \times 2^{m-(i+1)}$$

Binary Encoded Number
B4.1 Fixed Point Format

203     204

Binary Encoded Number
B4.2 Fixed Point Format

| 1/2 • | 8 | 4 | 2 | 1 |

| $b_4$ | $b_3$ | $b_2$ | $b_1$ | $b_0$ |

— 210

212

Fractional Part     Integer Part

212 —

| 1/4 | 1/2 • | 8 | 4 | 2 | 1 |

| $b_5$ | $b_4$ | $b_3$ | $b_2$ | $b_1$ | $b_0$ |

210 —

Fractional Part          Integer Part

FIG. 2

300

First Bit(s)

320

340

Separation
Circuit

Legacy Processing
Circuit

Legacy Output

380

Low-Resolution
Binary Encoded Number

Selection
Circuit

Binary Encoded Number

Contemporary
Processing Circuit

Contemporary Output

360

# FIG. 3

Binary Encoded Number

205

| $b_7$ | $b_6$ | $b_5$ | $b_4$ | $b_3$ | $b_2$ | $b_1$ | $b_0$ |

220

First Bit(s)

| $b_7$ |
| $b_6$ |

Separation Circuit 320

322

324

Configuration

Separator

222

| $b_5$ |
| $b_4$ |
| $b_3$ |
| $b_2$ |
| $b_1$ |
| $b_0$ |

Low-Resolution
Binary Encoded Number

# FIG. 4

First Bit(s)

Selection Circuit 380

382

S

0

Legacy Output

1

Contemporary Output

## FIG. 5

301

Second Bit

First Bit

320

320

340

Sep. Circuit

Sep. Circuit

Legacy Processing Circuit

Legacy Output

Low-Resolution Binary Encoded Number

360

Contemporary Output

380

Binary Encoded Number

Contemporary Processing Circuit

Selection Circuit

370

High-Resolution Binary Encoded Number

High-Resolution Processing Circuit

High-Resolution Output

## FIG. 6

Second Bit

First Bit

Selection Circuit 380

382

S
0
1

384

S
0
1

Legacy Output

Contemporary Output

High-Resolution Output

## FIG. 7

300

320
Separation
Circuit

Binary
Encoded
Number

Low-Resolution Binary
Encoded Number

340
Legacy Processing
Circuit

Legacy Output

380
Selection
Circuit

360
Contemporary
Processing Circuit

Contemporary
Output

First Bit(s)

## FIG. 8

**Modulation** — 400

| Modulation | 1/2 | 2/3 | 3/4 | 5/6 |
|---|---|---|---|---|
| BPSK | nMCS = 0 (bps = 0.5) MCS = 0.0 | | | |
| QPSK | nMCS = 1 (bps = 1.0) MCS = 1.0 | | nMCS = 2 (bps = 1.5) MCS = 2.0 | |
| 16 QAM | nMCS = 3 (bps = 2.0) MCS = 3.0 | | nMCS = 4 (bps = 3.0) MCS = 4.0 | |
| 64 QAM | | nMCS = 5 (bps = 4.0) MCS = 5.0 | nMCS = 6 (bps = 4.5) MCS = 6.0 | nMCS = 7 (bps = 5.0) MCS = 7.0 |
| 256 QAM | | | nMCS = 8 (bps = 6.0) MCS = 8.0 | nMCS = 9 (bps = 6.67) MCS = 9.0 |
| 1K QAM | | | nMCS = 10 (bps = 7.5) MCS = 10.0 | nMCS = 11 (bps = 8.33) MCS = 11.0 |
| 4K QAM | | | nMCS = 12 (bps = 9) MCS = 12.0 | nMCS = 13 (bps = 10.0) MCS = 13.0 |

**Coding Rate**

# FIG. 9

**Modulation** — 410

| Modulation | 1/2 | 2/3 | 3/4 | 5/6 | 7/8 |
|---|---|---|---|---|---|
| BPSK | nMCS = 0 (bps = 0.5) MCS = 0.0 | nMCS = 16 (bps = 0.67) MCS = 0.5 | | | |
| QPSK | nMCS = 1 (bps = 1.0) MCS = 1.0 | nMCS = 17 (bps = 1.33) MCS = 1.5 | nMCS = 2 (bps = 1.5) MCS = 2.0 | nMCS = 18 (bps = 1.67) MCS = 2.5 | |
| 16 QAM | nMCS = 3 (bps = 2.0) MCS = 3.0 | nMCS = 19 (bps = 2.67) MCS = 3.5 | nMCS = 4 (bps = 3.0) MCS = 4.0 | nMCS = 20 (bps = 3.33) MCS = 4.5 | |
| 64 QAM | | nMCS = 5 (bps = 4.0) MCS = 5.0 | nMCS = 6 (bps = 4.5) MCS = 6.0 | nMCS = 7 (bps = 5.0) MCS = 7.0 | |
| 256 QAM | | nMCS = 23 (bps = 5.33) MCS = 7.5 | nMCS = 8 (bps = 6.0) MCS = 8.0 | nMCS = 9 (bps = 6.67) MCS = 9.0 | |
| 1K QAM | | | nMCS = 10 (bps = 7.5) MCS = 10.0 | nMCS = 11 (bps = 8.33) MCS = 11.0 | nMCS = 27 (bps = 8.75) MCS = 11.5 |
| 4K QAM | | | nMCS = 12 (bps = 9) MCS = 12.0 | nMCS = 13 (bps = 10.0) MCS = 13.0 | nMCS = 29 (bps = 10.5) MCS = 13.5 |

**Coding Rate**

# FIG. 10

300

$b_4$

320

Separation
Circuit

340a

Pre-UHR
MCS-logic

$b_4=0$

380

Selection
Circuit

Q4.0 Binary
Encoded Number

R, QAM,
bps

UHR Additional
MCS-logic

$b_4=1$

B4.1 Binary Encoded Number

360a

# FIG. 11

301

$b_5$

$b_4$

320

Sep.
Circuit

320

Sep.
Circuit

340a

Pre-UHR
MCS-logic

380

382

Q4.0 Binary
Encoded Number

360a

UHR Additional
MCS-logic

384

Selection
Circuit

B4.1 Binary Encoded Number

370a

Future MCS-logic

R, QAM,
bps

B4.2 Binary Encoded Number

# FIG. 12

500

| Generate a low-resolution binary encoded number by removing a first bit from a binary encoded number in a fixed-point format | — 520 |

| Generate a legacy output based on the low-resolution binary encoded number | — 530 |

| Generate a contemporary output based on the binary encoded number | — 540 |

| Select the legacy output or the contemporary output based on the first bit | — 560 |

# FIG. 13

501

Generate a binary encoded number by removing a second bit from a high-resolution binary encoded number in a fixed-point format — 510

↓

Generate a low-resolution binary encoded number by removing a first bit from a binary encoded number in a fixed-point format — 520

↓

Generate a legacy output based on the low-resolution binary encoded number — 530

↓

Generate a contemporary output based on the binary encoded number — 540

↓

Generate a high resolution output based on the high-resolution binary encoded number — 550

↓

Select (i) the high-resolution output or (ii) the selecting of the legacy output or the contemporary output based on the second bit — 570

# FIG. 14

**EUROPEAN SEARCH REPORT**

Application Number

EP 25 21 0017

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2024/000112 A1 (GUANGDONG OPPO MOBILE TELECOMMUNICATIONS CORP LTD [CN]) 4 January 2024 (2024-01-04) | 1,3-13 | INV. H03M7/14 |
| A | * paragraph [0079] - paragraph [0087] * | 2 | ADD. H04L25/49 |
| A | KATAOKA TAKAFUMI KATAOKA@PL INFO KOCHI-TECH AC JP ET AL: "A framework for constructing javascript virtual machines with customized datatype representations", RESEARCH & DEVELOPMENT IN INFORMATION RETRIEVAL, ACM, 2 PENN PLAZA, SUITE 701NEW YORKNY10121-0701USA, 9 April 2018 (2018-04-09), pages 1238-1247, XP058632928, DOI: 10.1145/3167132.3167266 ISBN: 978-1-4503-5657-2 * page 1239 - page 1241 * | 1-13 | H04L27/00 |
| A | Chun Te Ewe ET AL: "Dual Fixed-Point: An Efficient Alternative to Floating-Point Computation" In: "SAT 2015 18th International Conference, Austin, TX, USA, September 24-27, 2015", 1 January 2004 (2004-01-01), Springer, Berlin, Heidelberg, XP055248225, ISBN: 978-3-540-74549-5 vol. 3203, pages 200-208, DOI: 10.1007/978-3-540-30117-2_22, * in particular section 3; page 200 - page 203 * | 1-13 | |

TECHNICAL FIELDS SEARCHED (IPC)

H03M
H04L

The present search report has been drawn up for all claims

| Place of search | Date of completion of the search | Examiner |
|---|---|---|
| The Hague | 17 February 2026 | Burchett, Stefanie |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P4C01)

## ANNEX TO THE EUROPEAN SEARCH REPORT
## ON EUROPEAN PATENT APPLICATION NO.

EP 25 21 0017

This annex lists the patent family members relating to the patent documents cited in the above-mentioned European search report.
The members are as contained in the European Patent Office EDP file on
The European Patent Office is in no way liable for these particulars which are merely given for the purpose of information.

17-02-2026

| Patent document cited in search report | Publication date | Patent family member(s) | | Publication date |
|---|---|---|---|---|
| WO 2024000112 A1 | 04-01-2024 | CN | 119404477 A | 07-02-2025 |
| | | EP | 4544746 A1 | 30-04-2025 |
| | | JP | 2025521605 A | 10-07-2025 |
| | | US | 2025126010 A1 | 17-04-2025 |
| | | WO | 2024000112 A1 | 04-01-2024 |

EPO FORM P0459

For more details about this annex : see Official Journal of the European Patent Office, No. 12/82